# EUROPÄISCHE PATENTSCHRIFT

(11) **EP 1 601 985 B1**
(45) Veröffentlichungstag und Bekanntmachung des Hinweises auf die Patenterteilung: **28.11.2007**
(21) Anmeldenummer: 03785585.5
(22) Anmeldetag: 18.12.2003
(51) Int. Cl.: G01R 31/34, H05B 6/02, H02K 15/00, H02K 15/02

(54) **BLECHPAKETPRÜFUNGSANORDNUNG**
LAMINATED CORE TESTING DEVICE
DISPOSITIF DE CONTROLE DE PAQUET DE TOLES

(30) Priorität: 12.03.2003 DE 10311182
(43) Veröffentlichungstag der Anmeldung: 07.12.2005
(73) Patentinhaber: SIEMENS AKTIENGESELLSCHAFT, 80333 München (DE)
(72) Erfinder: BACA, Matthias, 44534 Lünen (DE); HASCHKE, Peter, 46149 Oberhausen (DE); RICHTER, Claus-Georg, 45468 Mülheim a.d. Ruhr (DE); TWELLMANN, Hans-Bernd, 45473 Mülheim a.d. Ruhr (DE)
(86) Internationale Anmeldenummer: PCT/DE2003/004185
(87) Internationale Veröffentlichungsnummer: WO 2004/081594

(56) Entgegenhaltungen:
- EP-A- 0 384 987
- DE-A- 2 242 243
- DE-A- 3 925 047
- HAMER P S: "Acceptance testing of electric motors and generators" IEEE, Nr. PCIC-87-5, 2. Oktober 1988 (1988-10-02), Seiten 1291-1304, XP010519250
- PATENT ABSTRACTS OF JAPAN vol. 009, no. 212 (E-339), 29. August 1985 (1985-08-29) -& JP 60 074418 A (TATSUMI OKAMOTO;OTHERS: 01), 26. April 1985 (1985-04-26)
- PATENT ABSTRACTS OF JAPAN vol. 009, no. 212 (E-339), 29. August 1985 (1985-08-29) -& JP 60 074417 A (TATSUMI OKAMOTO;OTHERS: 01), 26. April 1985 (1985-04-26)

## Beschreibung

Die Erfindung betrifft eine Blechpaketprüfungsanordnung zur Prüfung von Blechpaketen in einem Generator, wobei die Blechpaketprüfungsanordnung eine parallel zu einer Rotationsachse des Generators liegende Erregerwicklung, die mit einem Wechselstrom liefernden Hochspannungs-Prüfgerät verbunden ist sowie eine Infrarot-Bilderfassungseinrichtung, die ausgebildet ist zum Erfassen von Infrarot-Strahlung, aufweist.

Die Erfindung betrifft weiterhin ein Verfahren zur Prüfung von Störungen in einem Stator eines Generators, wobei ein Wechselstrom lieferndes Hochspannungs-Prüfgerät mit einer parallel zu einer Rotationsachse des Generators liegenden Erregerwicklung verbunden ist und mit einer Infrarot-Bilderfassungseinrichtung Infrarot-Strahlungen in Richtung der Rotationsachse erfasst werden.

Im heutigen Generatorbau ist es erforderlich Generatoren für die kommunale und kommerzielle Energieerzeugung im Rahmen von Revisionen zur Schadensfrüherkennung auf Störungen zu untersuchen. Störungen können Schäden in der Rotorwicklung oder Schäden im Stator sein. Im Stator können unter anderem Schäden in den Blechpaketen oder in der Ständerwicklung auftreten. Die Blechpakete werden quer zu einer Rotationsachse eingebaut. Zur Aufnahme der Ständerwicklung, die in der Regel aus Kupferleitungen mit rechteckigem Querschnitt bestehen, sind die Blechpakete mit Nuten versehen. In die Nuten werden die Ständerwicklung isoliert eingelegt. Die Ständerwicklung wird gegen die Blechpakete isoliert.

Der Rotor eines Generators weist eine mit elektrischen Strom durchflossene Rotorwicklung auf, wobei die Stromstärke bei modernen Generatoren bis zu 10.000A beträgt. Der elektrische Strom wird in der Regel mittels Schleifringen und Kohlebürsten von einer externen Stromversorgung übertragen. Bei Grenzleistungsgeneratoren wird der Erregerstrom durch Erregermaschinen mit rotierenden Gleichrichterrädern erzeugt.

Mit dem elektrischen Strom wird ein rotierendes Magnetfeld erzeugt, das wiederum in der im Statorgehäuse befindliche Statorwicklung Spannungen induziert. In der Statorwicklung fließt ein elektrischer Strom mit beachtlich hohen Stromstärken. Die hohen Stromstärken führen zu einer Erwärmung der sich in den Nuten befindenden Statorwicklung. Die Isolation zwischen der Statorwicklung und dem Blechpaket könnte beschädigt werden. Tritt ein solcher Schaden auf, erwärmt sich in der lokalen Umgebung der beschädigten Isolation das Blechpaket. Weitere Schäden wären nicht auszuschließen.

Üblicherweise werden die Isolationen zwischen der Statorwicklung und den Blechpaketen auf Schäden untersucht. Eine gängige Prüfmethode ist, den Rotor auszubauen und einen Betriebszustand zu simulieren, der zur Erwärmung des Blechpakets führt. Wenn die Betriebstemperatur erreicht wird, wird mittels einer Infrarot-Kamera in einer Richtung parallel zur Rotationsachse eine Infrarot-Aufnahme der Statorwicklung und der Blechpakete erstellt. Störungen bzw. Schäden können als sogenannte Hot Spots identifiziert und lokalisiert werden. Vor einer Inbetriebnahme werden die Schäden behoben.

Eine Simulation des Betriebzustandes erfolgt heutzutage durch eine Anordnung, die einen Hochspannungsgenerator und mehrere Stränge einer Erregerwicklung aufweist. Die Stränge der Erregerwicklung werden parallel zur Rotationsachse verlegt. Der Hochspannungsgenerator ist mit der Erregerwicklung elektrisch verbunden und liefert eine Ausgangsspannung von bis zu 6kV bei einer Stromstärke von ungefähr 700 bis 800 A. Die Wechselspannung induziert in dem Blechpaket einen magnetischen Fluss bzw. ein magnetisches Wechselfeld die zu einer gewünschten Erwärmung durch Ummagnetisierungsverluste führt, die mit der Erwärmung im Betriebszustand vergleichbar ist.

Das Dokument "Acceptance testing of electric motors and generators", Hamer P. S. Paper No. PCIC-87-5, 1998, IEEE offenbart eine Blechpaketprüfungsanordnung zur Prüfung von Blechpaketen in einem Generator oder Motor, wobei die Blechpaketprüfungsanordnung eine parallel zu einer Rotationsachse des Generators bzw. Motors liegende Erregerwicklung, die mit einem Wechselstrom liefernden Hochspannungs-Prüfgerät verbunden ist sowie eine Infrarot-Bilderfassungseinrichtung, die ausgebildet ist zum Erfassen von Infrarot-Strahlung, aufweist.

Das Dokument DE-A-3925047 offenbart eine Vorrichtung zum induktiven Erwärmen von Gegenständen, wobei die Frequenz der Versorgungsspannung anhand eines steuerbaren Frequenzwandlers geändert werden kann.

Da die Generatoren meist vor Ort getestet werden, ist es nahezu unmöglich, einen Hochspannungsgenerator zur Verfügung zu haben. Es sind derzeit lediglich stationäre Hochspannungsgeneratoren bekannt, die in einem Kraftwerk nicht einsetzbar sind.

Die Prüfung der Blechpakete wurde bisher im Werk durchgeführt. Eine weitere Möglichkeit zur Prüfung der Statorwicklung und der Blechpakete ist die so genannte EL-CID-Messung, das allerdings eingeschränkt aussagefähig ist bei isoliert aufgebauten Ständerblechpaketen.

Aufgabe der Erfindung ist es, ein weiteres Verfahren und eine Vorrichtung zur Prüfung eines Generators anzugeben, das leicht transportiert werden kann.

Die auf die Blechpaketprüfungsanordnung hin gerichtete Aufgabe wird gelöst durch eine Blechpaketprüfungsanordnung gemäß Anspruch 1.

Die auf das Verfahren hin gerichtete Aufgabe wird gelöst durch ein Verfahren gemäß Anspruch 7.

Der Vorteil ist unter anderem darin zu sehen, dass eine Vorrichtung gefunden wurde, mit der es möglich ist, Generatoren vor Ort auf Schäden zu prüfen.

Zweckmäßigerweise weist die Blechpaketprüfungsanordnung einen regelbaren Frequenzumformer zum Umformen einer Grundfrequenz in eine höhere Frequenz.

Um die Möglichkeit zu schaffen, die Blechpaketprüfungsanordnung an eine Wechselstromversorgung anzuschließen, weist das Hochspannungs-Prüfgerät eine an eine Drehstromversorgung anschließbare Eingangsseite auf.

Zweckmäßigerweise weist die Drehstromversorgung eine dreiphasige 400V Wechselspannung auf.

Durch eine Ausführungsform, in der die Erregerwicklung zumindest zwei Leitungen aufweist, ist es möglich die Bauweise der Blechpaketprüfungsanordnung noch weiter zu verkleinern. Dadurch vergrößert sich die Transportfähigkeit der Blechpaketprüfungsanordnung.

Anhand der Beschreibung und der Figuren werden Ausführungsbeispiele beschrieben. Dabei haben mit den gleichen Bezugszeichen versehene Komponenten dieselbe Funktionsweise.

Dabei zeigen:
- Figur 1: den Aufbau einer Blechpaketprüfungsanordnung
- Figur 2: Infrarot-Aufnahme.

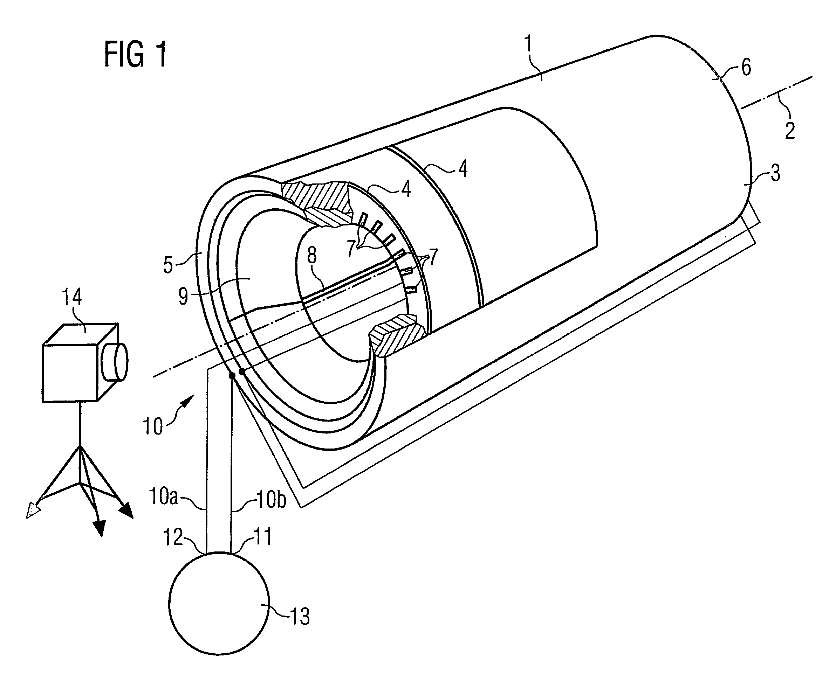

In Figur 1 ist der Aufbau einer Blechpaketprüfungsanordnung dargestellt. Ein nicht komplett dargestellter Generator weist ein Stator 1 auf. Der Stator 1 ist symmetrisch zu einer Rotationsachse 2 ausgebildet. Der Stator 1 weist ein Außengehäuse 3 auf. Senkrecht und symmetrisch zur Rotationsachse 2 sind Blechpakete 4 angeordnet. Aus Gründen der Übersichtlichkeit sind in der Figur 1 lediglich zwei Blechpakete 4 dargestellt. Die Blechpakete 4 werden von einem Statoranfang 5 zu einem Statorende 6 innerhalb des Außengehäuses 3 angeordnet. Die Blechpakete 4 werden in einer nicht näher dargestellten Weise in Richtung der Rotationsachse 2 befestigt.

Die Blechpakete 4 weisen mehrere Nuten 7 auf, die symmetrisch in Umfangsrichtung des Außengehäuses 3 angeordnet sind. Eine Statorwicklung, die aus mehreren Statorwicklungsstäben 8 ausgebildet ist, wird in einer nicht näher dargestellten Weise in den Nuten 7 der Blechpakete 4 angeordnet. Aus Gründen der Übersichtlichkeit ist in der Figur 1 lediglich ein Statorwicklungsstab 8 dargestellt.

Ein nicht dargestellter Rotor wird in einer Innenöffnung 9 des Generators um die Rotationsachse 2 drehbar gelagert. Der Rotor weist eine Rotorwicklung auf, die aus mehreren Spulengruppen besteht und durch die ein Erregerstrom von bis zu 10.000A fließt. Der Rotor wird über eine nicht dargestellte Dreheinrichtung in eine Drehung um die Rotationsachse 2 gebracht. Die Dreheinrichtung könnte aus einer Dampfturbine, einer Gasturbine oder einer Kombination aus Gas- und Dampfturbine bestehen.

Durch den Erregerstrom und der Drehbewegung des Rotors wird in der Statorwicklung eine elektrische Spannung induziert, die über nicht dargestellte EndStatorwicklungsstäbe als Nutzstrom zur Verfügung gestellt werden kann.

Die Spannungen und Ströme in der Ständerwicklung können im Betrieb Werte von bis zu 27.000V und bis zu 35.000A annehmen. Solch hohe Ströme rufen eine beträchtliche Wärmeentwicklung hervor.

Zwischen den Nuten 7 der Blechpakete 4 und den Statorwicklungsstäben 8 wird eine nicht näher dargestellte Isolation angebracht. Die Isolation verhindert ein unkontrolliertes Strömen des elektrischen Stromes und dadurch ein mögliche kritische Temperaturerhöhung.

In einem Prüfungszustand, das vor Ort durchgeführt werden kann, werden in Richtung der Rotationsachse 2 eine Erregerwicklung 10 angeordnet. Die Erregerwicklung 10 weist in dieser Ausführungsform zwei Erreger-Wicklungsleitungen 10a, 10b auf. Die Erregerwicklung kann in einer alternativen Ausführungsform mehrere Erreger-Wicklungsleitungen aufweisen. Die Erreger-Wicklungsleitungen 10a, 10b liegen vorzugsweise in der Rotationsachse 2. Die Erregerwicklung weist zwei Erregerwicklungsenden 11, 12 auf, die an ein Hochspannungs-Prüfgerät 13 angekoppelt ist. Das Hochspannungs-Prüfgerät 13 stellt einen Wechselstrom bei einer Frequenz höher als 50Hz einphasig bei einer regelbaren Ausgangsspannung von wenigstens 400V zur Verfügung.

In einer bevorzugten Ausführungsform liefert das Hochspannungs-Prüfgerät 13 ein regelbares und einphasiges Ausgangssignal mit einer Ausgangsspannung von wenigstens 400V und einer Ausgangsfrequenz von mehr als 400 Hz bis zu 600 Hz mit Sinusform. In einer weiteren bevorzugten Ausführungsform liefert das Hochspannungs-Prüfgerät 13 eine Ausgangsspannung von mehr als 3,0kV, insbesondere 2,0kV.

Das Hochspannungs-Prüfgerät 13 weist einen regelbaren Frequenzumformer zum Umformen einer Grundfrequenz in eine höhere Frequenz.

In einer alternativen Ausführungsform weist das Hochspannungs-Prüfgerät eine an eine Wechselstromversorgung anschließbare Eingangsseite auf. Die Wechselstromversorgung kann hierbei eine dreiphasige 400V Wechselspannung sein.

Darüber hinaus sind die geometrischen Ausmaße und das Gewicht des Hochspannungs-Prüfgerätes 13 derart, dass ein einfacher Transport möglich ist.

Überraschenderweise wurde festgestellt, dass durch die Ausgangsspannung, die Leistung und die Frequenz des Hochspannungs-Prüfgerätes 13 eine Situation simuliert werden kann, die einen Zustand erzeugt, der dem Zustand während des bestimmungsgemäßen Betriebes des Generators sehr nahe kommt.

Bisher wurden Blechpaketsprüfungen bei Frequenzen von 50Hz und Ausgangsspannungen von bis zu 6kV durchgeführt. Bislang gab es technische Vorbehalte, Blechpaketprüfungen bei höheren Frequenzen und bei niedrigeren Ausgangsspannungen durchzuführen.

Die Längsspannungen die bei der neuen Blechpaketprüfungsanordnungen erreicht werden, sind den Werten der Längsspannungen der bekannten Blechpaketprüfungsanordnungen nahezu identisch.

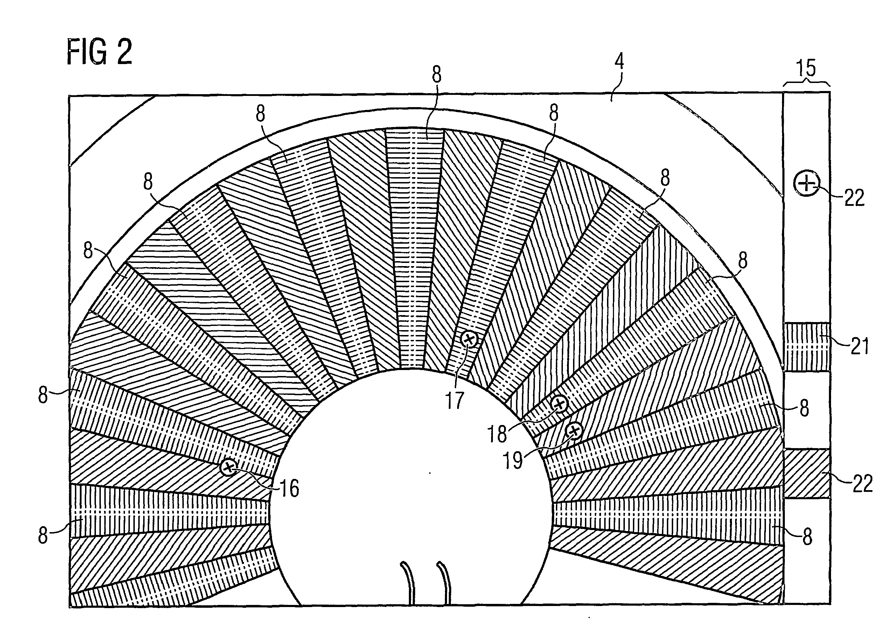

In Figur 2 ist eine stark vereinfachte Infrarot-Aufnahme zu sehen, die durch die Infrarot-Bilderfassungseinrichtung 14 während eines Prüfungsverlaufs erstellt wurde. Die Infrarot-Aufnahme zeigt einen Ausschnitt der Blechpakete 4 und dem Statorwicklungsstab 8. Es wird hierbei die Temperatur der Blechpakete 4 und des Statorwicklungsstabes 8 entsprechend einer Zuordnungsskala 15 dargestellt. Die Zuteilung einer Flächendarstellung und Temperatur ist in der Zuordnungsskala 15 zu entnehmen.

Die schraffiert dargestellte Temperatur 20 ist niedriger als die strich-punktierte dargestellte Temperatur 21. Die mit einem x dargestellte Temperatur 22 ist noch höher als die strichpunktierte Temperatur. Zum Beispiel liegt die Temperatur 20 bei 20°C, die Temperatur 21 bei 26°C und die Temperatur 22 bei 30°C.

Eine Infrarot-Bilderfassungseinrichtung 14 ist vorzugsweise in der Rotationsachse 2 angeordnet. Mit der Infrarot-Bilderfassungseinrichtung 14 wird die Möglichkeit geschaffen, Infrarot-Strahlung innerhalb des Außengehäuses 3 zu erfassen. Die Infrarot-Aufnahme zeigt eine Wärmeverteilung an den Blechpaketen 4, den Nuten 7 und den Statorwicklungsstäben 8.

Aus Gründen der Übersichtlichkeit werden in der Figur 2 lediglich drei Temperaturwerte dargestellt.

Die Infrarot-Aufnahme wird während eines Prüfungsverfahrens ausgewertet. Die Temperaturverteilung sollte möglichst homogen und symmetrisch zur Rotationsachse 2 sein. Der Infrarot-Aufnahme gemäß Figur 2 kann entnommen werden, dass an verschiedenen Stellen höhere lokale Temperaturen herrschen.

Diese verschiedenen Stellen können als Schäden 16, 17, 18, 19 identifiziert werden.

Die verschiedenen Stellen mit höherer lokaler Temperatur werden auch Hot Spots genannt. Durch die Identifikation und Lokalisierung von Schäden können Reparatur-Maßnahmen eingeleitet werden. Folgeschäden während eines bestimmungsgemäßen Betriebes können wirksam verhindert werden.

## Patentansprüche

1. Blechpaketprüfungsanordnung zur Prüfung von Blechpaketen (4) in einem Generator, wobei die Blechpaketprüfungsanordnung eine parallel zu einer Rotationsachse (2) des Generators liegende Erregerwicklung (10), die mit einem Wechselstrom liefernden Hochspannungs-Prüfgerät (13) verbunden ist sowie eine Infrarot-Bilderfassungseinrichtung (14), die ausgebildet ist zum Erfassen von Infrarot-Strahlung, aufweist, wobei die Blechpaketprüfungsanordnung zum Auswärten der durch die Infrarot-Bilderfassungseinrichtung (14) erfassten Infrarot-Aufnahmen auf Hot-spots, die auf Störungen im Blechpaket hindeuten, ausgebildet ist,
**dadurch gekennzeichnet, dass**
das Hochspannungs-Prüfgerät (13) eine Frequenz höher als 400Hz und eine Leistung einphasig bei einer regelbaren Ausgangsspannung von wenigstens 400V zur Verfügung stellt.

2. Blechpaketprüfungsanordnung nach Anspruch 1,
**dadurch gekennzeichnet, dass**
das Hochspannungs-Prüfgerät (13) einen regelbaren Frequenzumformer zum Umformen einer Grundfrequenz in eine höhere Frequenz aufweist.

3. Blechpaketprüfungsanordnung nach Anspruch 1 oder 2,
**dadurch gekennzeichnet, dass**
das Hochspannungs-Prüfgerät (13) eine an eine Drehstromversorgung anschließbare Eingangsseite aufweist.

4. Blechpaketprüfungsanordnung nach Anspruch 3,
**dadurch gekennzeichnet, dass**
die Drehstromversorgung eine dreiphasige 400V Wechselspannung aufweist.

5. Blechpaketprüfungsanordnung nach einem der Ansprüche 1 bis 5,
**dadurch gekennzeichnet, dass**
die Erregerwicklung (10) zumindest zwei Leitungen umfasst.

6. Blechpaketprüfungsanordnung nach einem der Ansprüche 1 bis 6,
**dadurch gekennzeichnet, dass**
das Hochspannungs-Prüfgerät (13) ausgebildet ist als transportierbares Gerät.

7. Verfahren zur Prüfung von Störungen in einem Stator (1) eines Generators,
wobei ein Wechselstrom lieferndes Hochspannungs-Prüfgerät (13) mit einer parallel zu einer Rotationsachse (2) des Generators liegenden Erregerwicklung (10) verbunden ist und mit einer Infrarot-Bilderfassungseinrichtung (14) Infrarot-Strahlen in Richtung der Rotationsachse (2) erfasst werden,
**dadurch gekennzeichnet, dass**
das Hochspannungs-Prüfgerät (13) bei einer Frequenz höher als 400Hz eine Leistung einphasig bei einer regelbaren Ausgangsspannung von wenigstens 400V zur Verfügung stellt und
die erfassten Infrarot-Aufnahmen auf Hot-Spots untersucht werden, die auf Störungen im Stator hindeuten.

## Claims

1. Laminated core testing arrangement for the purpose of testing laminated cores (4) in a generator, the laminated core testing arrangement having a field winding (10), which lies in parallel with an axis of rotation (2) of the generator and is connected to a high-voltage testing device (13) producing alternating current, as well as an infrared image detection device (14) which is designed to detect infrared radiation, the laminated core testing arrangement being designed to analyse the infrared recordings detected by the infrared image detection device (14) for hot-spots, which indicate faults in the laminated core,
**characterized in that**
the high-voltage testing device (13) makes available a frequency which is greater than 400 Hz and a power in single-phase form at an output voltage of at least 400 V which can be regulated.

2. Laminated core testing arrangement according to Claim 1,
**characterized in that**
the high-voltage testing device (13) has a controllable frequency converter for the purpose of converting a fundamental frequency into a higher frequency.

3. Laminated core testing arrangement according to Claim 1 or 2,
**characterized in that**
the high-voltage testing device (13) has an input side which can be connected to a three-phase power supply.

4. Laminated core testing arrangement according to Claim 3,
**characterized in that**
the three-phase power supply has a three-phase 400 V AC voltage.

5. Laminated core testing arrangement according to one of Claims 1 to 5,
**characterized in that**
the field winding (10) comprises at least two lines.

6. Laminated core testing arrangement according to one of Claims 1 to 6,
**characterized in that**
the high-voltage testing device (13) is in the form of a transportable device.

7. Method for testing for faults in a stator (1) of a generator,
a high-voltage testing device (13) producing alternating current being connected to a field winding (10) which lies in parallel with an axis of rotation (2) of the generator, and infrared beams being detected in the direction of the axis of rotation (2) using an infrared image detection device (14),
**characterized in that**
the high-voltage testing device (13) at a frequency of greater than 400 Hz makes available a power in single-phase form at an output voltage of at least 400 V which can be regulated, and
the detected infrared recordings are inspected for hot-spots which point towards faults in the stator.

## Revendications

1. Dispositif de contrôle de paquets de tôles pour contrôler des paquets (4) de tôles d'une génératrice, le dispositif de contrôle de paquets de tôles ayant un enroulement (10) d'excitation parallèle à l'axe (2) de rotation de la génératrice et relié à un appareil (13) de contrôle en haute tension, fournissant du courant alternatif, ainsi qu'un dispositif (14) de détection d'images infrarouges qui est conçu pour détecter du rayonnement infrarouge, le dispositif de contrôle de paquets de tôles étant constitué pour exploiter les enregistrements infrarouges, pris par le dispositif (14) de détection d'images infrarouges, de hot-spots qui indiquent des défauts dans le paquet de tôles,
**caractérisé en ce que**
l'appareil (13) de contrôle de haute tension met à disposition une fréquence plus grande que 400 Hz et une puissance monophasée pour une tension de sortie réglable d'au moins 400 V.

2. Dispositif de contrôle de paquets de tôles suivant la revendication 1, **caractérisé en ce que** l'appareil (13) de contrôle de haute tension a un convertisseur de fréquence réglable pour convertir une fréquence fondamentale en une fréquence plus haute.

3. Dispositif de contrôle de paquet de tôles suivant la revendication 1 ou 2, **caractérisé en ce que** l'appareil (13) de contrôle de haute tension a un côté d'entrée pouvant être raccordé à une alimentation en courant triphasé.

4. Dispositif de contrôle de paquet de tôles suivant la revendication 3, **caractérisé en ce que** l'alimentation en courant triphasé a une tension alternative triphasée de 400 V.

5. Dispositif de contrôle de paquet de tôles suivant l'une des revendications 1 à 4, **caractérisé en ce que** l'enroulement (10) d'excitation comprend au moins deux lignes.

6. Dispositif de contrôle de paquet de tôles suivant l'une des revendications 1 à 5, **caractérisé en ce que** l'appareil (13) de contrôle de haute tension est constitué sous la forme d'un appareil transportable.

7. Procédé de contrôle de défauts dans le stator (1) d'une génératrice,
dans lequel on relie un appareil (13) de contrôle de haute tension fournissant du courant alternatif à un enroulement (10) d'excitation parallèle à un axe (2) de rotation de la génératrice et on détecte par un dispositif (14) de détection d'images infrarouges du rayonnement infrarouge dans la direction de l'axe (2) de rotation,
**caractérisé en ce que** l'appareil (13) de contrôle de haute tension met à disposition une fréquence plus grande que 400 Hz et une puissance monophasée pour une tension de sortie réglable d'au moins 400 V, et
on étudie sur les enregistrements infrarouges détectés les hot-spots qui indiquent des défauts dans le stator.
